# EUROPEAN PATENT APPLICATION

(11) **EP 4 722 885 A1**
(43) Date of publication of application: **08.04.2026**
(21) Application number: 24899811.4
(22) Date of filing: 03.12.2024
(51) Int. Cl.: G06F 3/06, G11C 16/14

(54) **MEMORY MANAGEMENT METHOD AND APPARATUS, AND STORAGE SYSTEM AND COMPUTER-READABLE MEDIUM**

(30) Priority: 06.12.2023 CN 202311672217
(71) Applicant: GUANGDONG OPPO MOBILE TELECOMMUNICATIONS CORP., LTD., Dongguan, Guangdong 523860 (CN)
(72) Inventor: ZHANG, Changkun, Dongguan, Guangdong 523860 (CN); ZHANG, Wensheng, Dongguan, Guangdong 523860 (CN); LIU, Derong, Dongguan, Guangdong 523860 (CN); SHAO, Ziqiao, Dongguan, Guangdong 523860 (CN)
(74) Representative: Novagraaf Technologies
(86) International application number: PCT/CN2024/136448
(87) International publication number: WO 2025/119173

(57) **Abstract**

A memory management method, and a storage system (10) are provided. The method may include: determining (S201) a target pre-erasing mode among an automatic mode and an active mode, wherein in the automatic mode, the memory automatically performs a pre-erase operation on the memory (200), and in the active mode, the memory (200) performs the pre-erase operation according to an instruction sent by a host (100); and performing (S202) the pre-erase operation on the memory (200) based on the target pre-erase mode.

## Description

### CROSS REFERENCE TO RELATED APPLICATIONS

This application claims the priority of Chinese Patent Application No. 202311672217.2 filed December 6, 2023 and entitled "memory management method, memory management apparatus, storage system, and computer-readable medium", which is herein incorporated by reference in its entirety.

### TECHNICAL FIELD

The present disclosure relates to the field of mobile terminal technologies, more particularly to a memory management method, a memory management apparatus, a storage system, and a computer-readable medium.

### BACKGROUND

Currently, in a flash memory, especially a NAND-type flash memory, a pre-erase operation may usually need to be performed. Generally, when such a memory is full of data in a current block and switches to a new block, it may first perform an erase process on the new block, and then write data into the new block.

### SUMMARY

The present disclosure provides a memory management method, a memory management apparatus, a storage system, and a computer-readable medium, which may overcome the aforementioned defects.

According to a first aspect of the present disclosure, a memory management method performed by a host of a storage system may be provided. The storage system may further include a memory. The host may be connected to the memory. The method may include: determining a target pre-erase mode among an automatic mode and an active mode; wherein in the automatic mode, the memory automatically performs a pre-erase operation on the memory; in the active mode, the memory performs, according to an instruction sent by the host, the pre-erase operation; and, performing, based on the target pre-erase mode, the pre-erase operation on the memory.

According to a second aspect of the present disclosure, a memory management apparatus applied to the host of the storage system may be provided. The storage system may further include the memory. The host may be connected to the memory. The apparatus may include a determining unit and an erasing unit. The determining unit may be configured to determine the target pre-erase mode among the automatic mode and the active mode. In the automatic mode, the memory may automatically perform the pre-erase operation on the memory. In the active mode, the memory may perform, according to the instruction sent by the host, the pre-erase operation. The erasing unit may be configured to perform, based on the target pre-erase mode, the pre-erase operation on the memory.

According to a third aspect of the present disclosure, a storage system may be further provided in the present disclosure. The storage system may include the host and the memory. The host may be connected to the memory. The host may be configured to execute the aforementioned method.

According to a fourth aspect of the present disclosure, a computer-readable medium may be further provided in the present disclosure. The computer-readable medium may store a program code executable by a processor. The program code, when being executed by the processor, may enable the processor to execute the aforementioned method.

### BRIEF DESCRIPTION OF THE DRAWINGS

In order to more clearly illustrate technical schemes in the present disclosure, the drawings required in description of the embodiments will be briefly introduced below. Obviously, the drawings in the following description are only some embodiments of the present disclosure. For those of ordinary skills in the art, other drawings could be obtained based on these drawings without creative efforts.
Fig. 1 is a schematic diagram of a storage system according to an embodiment of the present disclosure.
Fig. 2 is a method flowchart of a memory management method according to an embodiment of the present disclosure.
Fig. 3 is a schematic interaction diagram of an automatic mode and an active mode according to another embodiment of the present disclosure.
Fig. 4 is a schematic effect diagram of an automatic mode and an active mode according to another embodiment of the present disclosure.
Fig. 5 is a schematic format diagram of a UPIP according to an embodiment of the present disclosure.
Fig. 6 is a schematic diagram of an EHS field according to an embodiment of the present disclosure.
Fig. 7 is a method flowchart of a memory management method according to another embodiment of the present disclosure.
Fig. 8 is a schematic diagram of an operation at block S780 of Fig. 7.
Fig. 9 is a module block diagram of a memory management apparatus according to an embodiment of the present disclosure.
Fig. 10 is a storage unit for storing or carrying a program code configured to implement the method according to an embodiment of the present disclosure.

### DETAILED DESCRIPTION

In order to enable those of ordinary skills in the art to better understand the technical schemes of the present disclosure, technical schemes in embodiments of the present disclosure will be described clearly and thoroughly in connection with accompanying drawing of the embodiments of the present disclosure. Obviously, the described embodiments are only a part of the embodiments, but not all of them. Generally, the components of the embodiments of the present disclosure described and illustrated in the accompanying drawings herein may be arranged and designed in various different configurations. Therefore, the following detailed description of the embodiments of the present disclosure provided in the accompanying drawings is not intended to limit the claimed scope of the present disclosure, but only represents selected embodiments of the present disclosure. All other embodiments obtained by a person of ordinary skills in the art based on embodiments of the present disclosure without creative efforts should all be within the protection scope of the present disclosure.

It should be noted that, similar reference numerals and letters may denote similar items in the following drawings. Therefore, once an item is defined in one drawing, it may not need to be further defined and explained in subsequent drawings. Meanwhile, in the description of the present disclosure, the terms "first" and "second" are for the purpose of distinguishing description only, and should not be construed as indicating or implying relative importance.

Currently, in a flash memory, especially a NAND-type flash memory, a pre-erase operation may usually need to be performed. Generally, in a host system which employs a universal flash storage (UFS) as a storage device, a firmware of the UFS may manage a medium (the NAND flash) by taking a virtual block (VB) as a unit. When a UFS device is full of data in a current block and switches to a new block, the UFS device may first perform an erase process (at the millisecond level) on the new block, and then write program data into the new block. This is because a medium in an erase state has poor stability, and cannot be used for data writing after being retained for a certain period of time.

The pre-erase operation may refer to a process in which a block where data is to be written is erased in advance before a write operation to the flash memory is performed. This process may usually be managed and executed by a controller. In a NAND-type flash memory, the data may only be erased and written by taking a block as a unit. Therefore, if new data is to be written into a block that already stores old data, the entire block may need to be erased first, and then a write operation may be performed. This may lead to an operation process called "Erase-Write". The purpose of the pre-erase operation may be to erase the block for storing data in advance before an actual write operation is performed, so as to reduce a write delay. In this way, during the actual write operation, the controller may not need to perform an erase operation again, thereby accelerating a write speed of the memory and reducing errors that may occur during writing. In practical applications, for the flash memory, the pre-erase operation may usually be managed and executed by the controller. When the controller receives a request for the write operation, the controller may check whether the block, where the data is to be stored, has been erased. If the block has not been erased, the controller may automatically perform the erase operation, and then perform the write operation.

Due to the above-mentioned strategy of erasing first and then writing, when a write load is high, the flash memory (for example, the UFS device) may have a period of time at the millisecond level, during which data cannot be written. Therefore, by erasing a part of blocks in advance and reducing the time used by the UFS for block switching, write performance of the device may be significantly enhanced, and at the same time, a maximum delay caused by the erase operation during a block switching process may be reduced.

However, the inventors have found in their research that, the existing pre-erase schemes may usually have the following shortcomings.
1) A relatively fixed pre-erase volume threshold: in the current autonomous pre-erase scheme of a device, the pre-erase volume may be determined by the device itself, and the pre-erase operation may be performed to a set threshold when the device is idle. To obtain greater performance benefits, the threshold should be expanded as much as possible. However, considering stability and a situation where there are too few idle blocks, the threshold may not be too great. Therefore, the device may select a threshold that balances benefits and risks. This threshold may be relatively fixed, and may not adapt to changes in the write operation of the host.
2) A stability risk of retained pre-erased blocks: currently, the device may not know the write operation of the host, and a pre-erase threshold may be relatively fixed, so there may always be a part of or some of pre-erased blocks in the device. When the host does not perform write operations for a period of time, the pre-erased blocks may easily have stability risks.

Therefore, setting a reasonable pre-erase strategy may be extremely important.

To overcome the above-mentioned defects, the embodiments of the present disclosure may provide a memory management method, which may adjust a pre-erase mode adaptively in combination with an actual data writing situation of an electronic device.

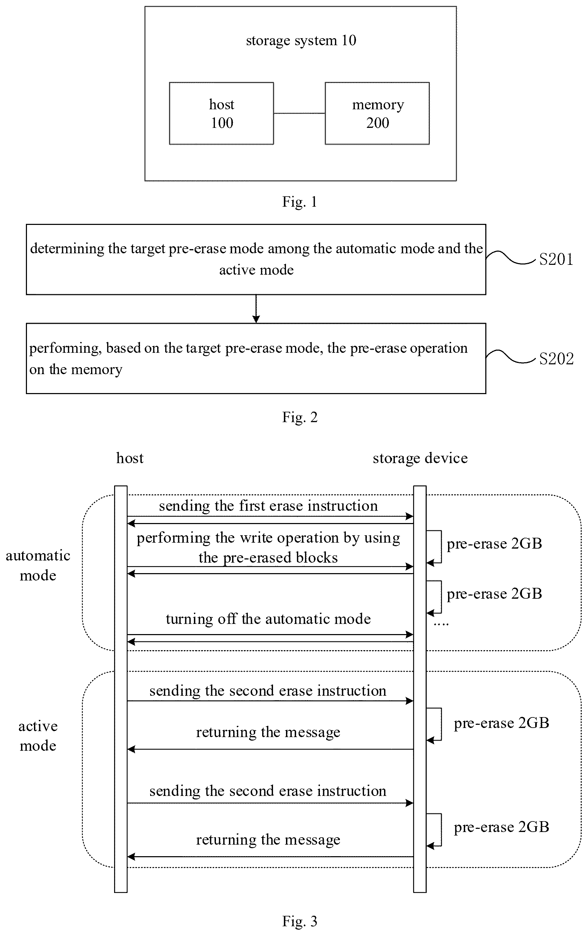

The memory management method provided by the embodiments of the present disclosure may be applied to a system composed of a host using the flash memory. As illustrated in Fig. 1, the storage system 10 may include a host 100 and a memory 200. The host 100 may be connected to the memory 200. For example, the host 100 may be an electronic device. The electronic device may be a smart phone, a tablet computer, an E-book, or other devices that may run application programs. In the embodiments of the present disclosure, the host 100 may be a smart phone. The memory 200 may be the above-mentioned flash memory. For example, the memory 200 may be a UFS.

The memory 200 may be a built-in memory of the host 100. That is to say, the memory 200 may be integrated into a motherboard of the host 100. The memory 200 may be used as a random-only memory (ROM) of a mobile phone, and may be configured to store an operating system, an application program, and user data. In addition, the memory 200 may be an external memory of the host 100. That is, the memory 200 may be a peripheral device of the host 100. For example, taking a case as an example where the memory 200 is the universal flash storage (UFS), the host 100 may be connected to the memory 200 through a USB interface. Of course, the UFS storage device may also be designed as a removable memory card, similar to a traditional SD card or microSD card. In this way, a user may insert the UFS storage device into a USB interface of the mobile phone, and may perform data transmission and access through the USB interface. In the embodiments of the present disclosure, there is no limitation on whether the memory 200 is an external memory or a built-in memory of the host 100. The host may be configured to execute the following embodiments.

As illustrated in Fig. 2, the method may be applied to the above-mentioned host. For the convenience of description, in the following embodiments, a case where the memory is the UFS may be used as an example for description. Of course, the memory may also be of another type, which is not limited herein. The method may include the operations from the operation at block S201 to the operation at block S202.

The operation at block S201: determining a target pre-erase mode among an automatic mode and an active mode.

In some embodiments, the host may usually use two pre-erase modes, which may be the automatic mode and the active mode respectively. The automatic mode may also be called an Auto mode. In the Auto mode, the UFS may automatically perform the pre-erase operation. When the host sends a write command, the UFS device may automatically detect a status of a target physical block, and may perform the erase operation if necessary. In the Auto mode, the host may not need to explicitly send a pre-erase command, and the erase operation may be handled by the UFS device itself. The active mode may also be called a Host Trigger mode. In the Host Trigger mode, the host may need to explicitly send the pre-erase command to trigger the erase operation. After the host sends the pre-erase command, the UFS device may perform the erase operation according to requirements of the command. In this mode, the host may control, more accurately, when to perform the erase operation. That is to say, in the automatic mode, the memory may automatically perform the pre-erase operation on the memory. In the active mode, the memory may perform the pre-erase operation according to an instruction sent by the host.

As illustrated in Fig. 3, Fig. 3 illustrates differences between the automatic mode and the active mode. In the automatic mode, the host may send a first erase instruction, i.e., "Write (10) EHS: open auto pre-erase". The storage device may respond to the first erase instruction and enter the automatic mode. In the automatic mode, the storage device may pre-erase 2GB of free physical blocks to obtain 2GB of pre-erased blocks. Then, the host may perform the write operation by using the pre-erased blocks, i.e., "Write cmds, use pre erase blocks". The memory may detect that the pre-erased blocks have been used and may automatically pre-erase 2GB of free physical blocks again. This process may be repeated until the automatic mode is turned off, i.e., "Write (10) EHS: close auto pre-erase". As illustrated in Fig. 3, it may be seen that, in the active mode, each pre-erase operation may be actively triggered by the host. Specifically, the pre-erase operation may be actively triggered according to feedback message returned by the memory, which will be described in detail later.

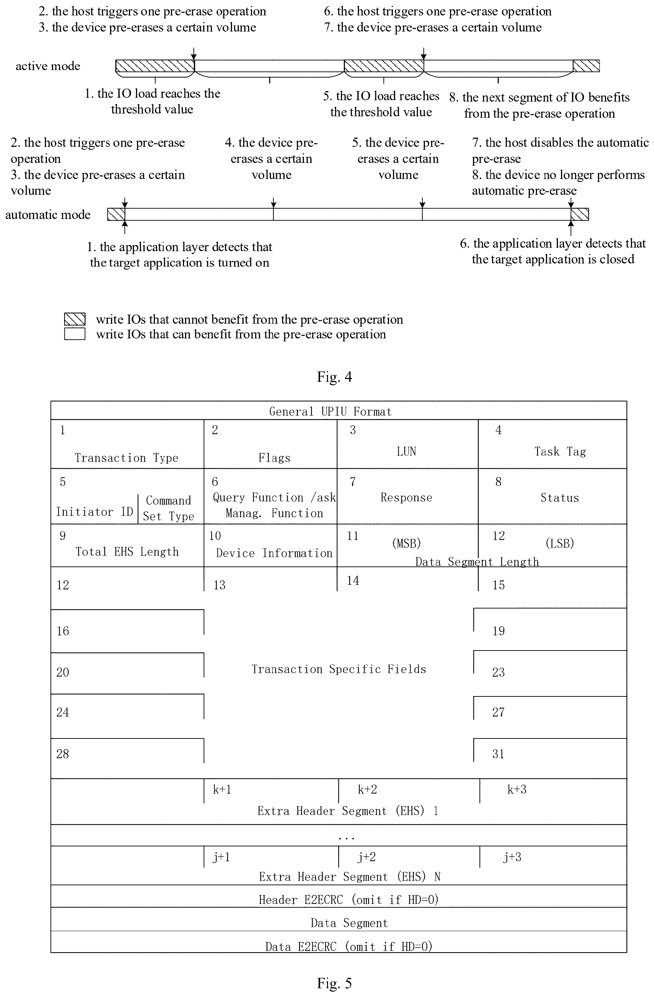

Specifically, beneficial effects of the automatic mode and the active mode are illustrated in Fig. 4.

It may be seen that, in the active mode (the Host Trigger mode), the pre-erase volume may be fully controllable by the host. In this way, a stability risk caused by retention of pre-erased blocks may be effectively prevented. However, an input/output (IO) coverage rate may be less than that in the automatic mode (Auto mode) mainly because that: the Host Trigger mode may trigger the pre-erase operation only after a large number of write IOs (write operations) occur, which has a certain time lag and may not ensure that all IOs can enjoy the pre-erase benefit. As may be seen from the aforementioned conditions for sending a second erase operation, a second erase instruction may be sent only when it is determined that a write rate is greater than a current first specified threshold. Then, before the write rate reaches the first specified threshold, a plurality of write operations may have been performed. As illustrated in Fig. 4, in the active mode, the write operations during a time period filled with diagonal lines may not benefit from the pre-erase operation.

The Auto mode may have a greater IO coverage rate, but may not be fully controllable by the host. If the Auto mode is always active, there may be a stability problem caused by the erased blocks not being used for a long time. Therefore, when it is determined that there is a scenario with a large number of sequential writes, the automatic mode may be turned on, such that the write operations may obtain the pre-erase benefit to the greatest extent. The IO coverage rate may refer to a ratio of the time period during which write operations enjoy the pre-erase benefit to a total time period of all write operations. The pre-erase benefit may refer to that, the write operations may use the pre-erased blocks.

In the present disclosure, based on aforementioned characteristics of the active mode and the automatic mode, one mode may be selected, according to actual requirements, as the target pre-erase mode from the automatic mode and the active mode, so as to perform the pre-erase operation.

In some embodiments of the present disclosure, the target pre-erase mode may be determined based on an application scenario of a storage system. For example, the application scenario may be a scenario where data is written to the UFS of the storage system. As mentioned above, a purpose of the pre-erase operation may be to erase the data in the storage device before writing new data, so as to ensure stability and security of a data writing process. Therefore, for different data write volumes, there may be different requirements for the volume of the physical blocks used in the pre-erase operation. To make the pre-erase operation more reasonable, it may be necessary to determine a current data writing situation of the storage system (i.e., the application scenario) before determining the pre-erase operation mode.

In some embodiments, the application scenario may reflect the data write volume of the storage system at present or within a certain time period in the future (i.e., a target time period). Therefore, a plurality of scenarios may be preset, and each scenario may match with a different data write volume. The data write volume may represent the possible data write volume in the scenario. For example, the data write volume may be: a maximum data write volume in the scenario, i.e., a historical peak value of the data write volume in the scenario; or, a historical average value of the data write volume in the scenario. Therefore, for different scenarios, the scenario may be determined by analyzing a size of data volume written into the UFS of the storage system within a historical time period before a current moment. A data range for the data write volume of the current historical time period may be determined by counting the volume of data written into the UFS within the historical time period. Then, the current application scenario may be determined based on the preset scenarios matching with different data ranges.

In some embodiments, after the application scenario is determined, the target pre-erase mode may be determined, based on the application scenario, among the automatic mode and the active mode.

In the embodiments of the present disclosure, the application scenarios of the storage system may be divided into a first scenario and a second scenario. The data write volume of the first scenario may be greater than that of the second scenario. A preset data write volume may represent a data writing capability matching with the scenario That is, the preset data write volume may be an estimation of the maximum data write volume under this scenario.

In the embodiments of the present disclosure, compared with the second scenario, the first scenario may be a scenario with a large volume of data writing. That is to say, in the first scenario, the storage system may have a possibility of writing a great volume of sequential data into the memory. While in the second scenario, the volume of data written into the memory may usually be less.

In some other embodiments, the target pre-erase mode may also be determined based on the application program running on the host. For example, determining the application program running on the host; determining, based on the running application program, the target pre-erase mode among the automatic mode and the active mode. Different application programs may have different requirements for data write volume and different requirements for write rate. Therefore, different application programs may have different requirements for the automatic mode and the active mode. Thus, modes matching with different applications may be preset to obtain a mode correspondence relationship. It may be determined, based on this mode correspondence relationship, whether the current application program should adopt the active mode or the automatic mode. Details will be described in subsequent embodiments.

In the embodiments of the present disclosure, different pre-erase modes may match with different pre-erase strategies. A pre-erase strategy may specify a timing of the pre-erase operation, the volume of a pre-erased block, or the like. The pre-erased block may refer to a physical block in the memory on which the pre-erase operation has been performed. The volume of the pre-erased blocks may refer to the number of physical blocks of a specified volume in the memory on which the pre-erase operation has been performed.

Therefore, through the above-mentioned correspondence relationship, the pre-erase mode matching with the current application scenario of the storage system may be determined. This determined mode may be adopted as the target pre-erase mode for the memory.

The operation at block S202: performing, based on the target pre-erase mode, the pre-erase operation on the memory.

As mentioned above, different pre-erase modes may specify pre-erase strategies such as the timing of pre-erase, the volume of pre-erased block, and an executor of the pre-erase operation. After determining the target pre-erase mode matching with the current application scenario of the storage system, the pre-erase operation may be performed, based on the target pre-erase strategy matching with the target pre-erase mode, on the memory. Different pre-erase operations would be described in subsequent embodiments according to different pre-erase modes.

After determining the target pre-erase mode, a pre-erase instruction matching with this target pre-erase mode may be determined. The pre-erase instruction may be sent to the memory, such that the memory may perform, based on the pre-erase instruction, the pre-erase operation. In the embodiments of the present disclosure, the host may issue the pre-erase instruction to the memory in three manners.

The first manner: the pre-erase command may be added to a preset field of a specified instruction to be sent to the memory, so as to obtain a target instruction. The target instruction may be sent to the memory, such that the memory may perform the pre-erase operation based on the pre-erase command. The specified instruction to be sent to the memory may be a write instruction or a read instruction (i.e., a WRITE/READ command) that the host currently needs to send to the memory. The preset field may be an EHS field or another field of the specified instruction.

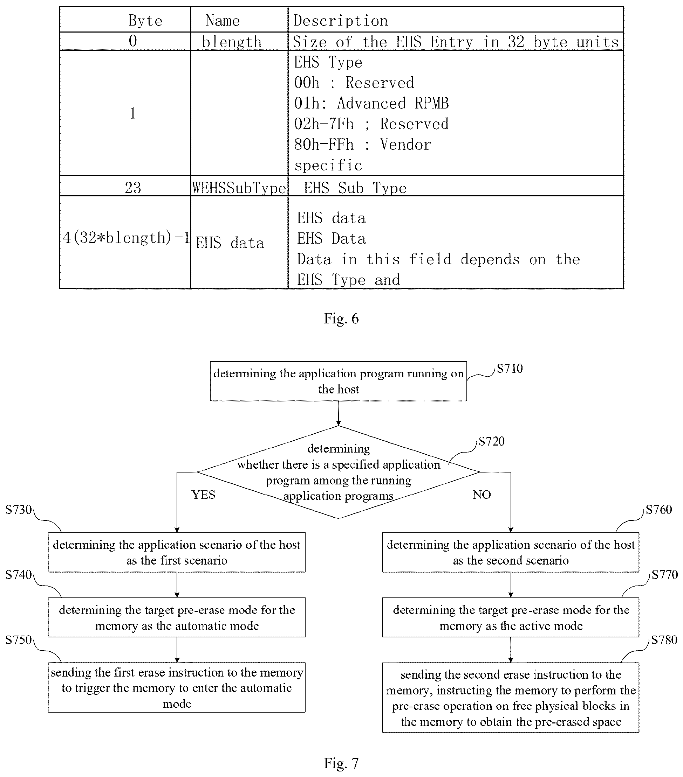

In some embodiments of the present disclosure, the specified instruction may be a read instruction or a write instruction in a UFS protocol information unit (UPIU). The preset field may be an Extra Header Segment (EHS). The format of the UPIU may be illustrated in Fig. 5. It may be seen that, the UPIU may include the EHS field. A definition of the EHS field in the UPIU is illustrated in Fig. 6. It may be seen that, the EHS may define the type of a specific instruction, parameters, and specific content of the specific instruction, so the pre-erase command may be added to the EHS.

The UPIU is a basic protocol for communication in UFS. It is a standard command format configured for control and data transmission between the UFS devices, and may include commands and data structures for communication. The UPIU may include various commands for reading and writing, status information, error codes, and some extra header information (such as the Extra Header Segment (EHS)). The EHS may be a part of the UPIU. The EHS may include extended header information, and may be configured to carry some extra control information or metadata. The EHS may be configured to transmit auxiliary information specific to commands or data transmission, so as to support more complex operations or provide extra context information.

As an example, an identifier of the pre-erase command may be determined first. Then, an EHS data structure may be configured. According to a definition in the UFS specification, a data structure of the pre-erase command to be added to the EHS may need to be determined. The data structure may include a command type, command parameters, length field, or the like. Then, the data structure and identifier of the pre-erase command may be encapsulated in the EHS field of the UPIU. The EHS field may be extended content of the aforementioned specified instruction.

In addition, the memory may need to be configured adaptively, such that, after receiving the specified instruction, the memory may parse the EHS field of the instruction to obtain the pre-erase command. When an execution condition is met, the memory may execute the pre-erase command. The implementation of the execution condition may refer to subsequent embodiments, which would not be repeated here.

Therefore, by way of adding the pre-erase command to the preset field of the specified instruction to be sent to the memory, the specified instruction that is originally to be sent to the memory may also include the pre-erase command. Thus, there is no need to send a separate pre-erase command in addition to the specified instruction. In other words, there is no need to generate additional interaction due to sending a separate pre-erase command, in this way, impacts of an extra interaction on real-time performance for users may be prevented.

The second manner: obtaining the pre-erase command matching with the target pre-erase mode; generating, based on the UPIU protocol, the pre-erase instruction from the pre-erase command; sending the pre-erase instruction to the memory, such that the memory may perform, based on the pre-erase instruction, the pre-erase operation. As an example, a UPIU instruction (i.e., the pre-erase instruction) containing an erase command may be sent to the UFS device to trigger the pre-erase operation by means of creating an Erase Command data packet, encapsulating the Erase Command into the UPIU, configuring a UPIU header information, and sending a UPIU. For example, a separate UPIU may be configured to issue the pre-erase instruction. For example, a WRITE BUFFER command may be configured to define a vendor command for pre-erase. The WRITE BUFFER command may include functions in the following aspects: data writing; buffer arrangement; or, data transmission preparation. Data writing: the command may instruct the storage device to receive a certain volume of data and write the data into the buffer of the device. Buffer management: The WRITE BUFFER command may involve management of an internal buffer of the device; the management may include operations such as clearing, refreshing, or allocating the buffer. Data transmission preparation: some storage devices may use the WRITE BUFFER command to prepare for data transmission, such that the data may be efficiently transmitted to a specific location in the memory. As an example, according to the UFS memory specification, a WRITE BUFFER command may be configured to define a specific vendor command for performing the erase operation. The structure and content of the specific vendor command may need to be constructed according to the specification document of the UFS memory. In the vendor command, a command code and parameters may be defined to instruct the memory to perform the erase operation. The Vendor Command may be sent, that is, the constructed vendor command may be sent to the UFS memory using the UPIU.

The difference between the second manner and the first manner is as follows: in the first manner, the host sends the specified instruction, and the preset field of the specified instruction contains the pre-erase command. The pre-erase command may serve as extended information in the preset field of the specified instruction. For example, if the specified instruction is the write instruction of the UPIU protocol, the pre-erase command may be an extended content of the write instruction. The host may send the specified instruction to the memory. The memory may parse content of the preset field of the specified instruction to obtain the pre-erase command. At the same time, the memory may respond to the specified instruction, and perform the operation matching with the specified instruction. For example, if the specified instruction is the write instruction, the memory may respond to the write instruction to perform the write operation, and respond to the pre-erase command to perform the pre-erase operation at the same time. In the second manner, the pre-erase instruction sent by the host is the pre-erase instruction directly defined through the UPIU protocol. Therefore, after receiving the instruction, the memory may respond to the pre-erase instruction and perform the pre-erase operation.

The third manner: the pre-erase command matching with the target pre-erase mode may be obtained. The pre-erase command may be issued through a preset request such as a query request or a task management request. The query request (i.e., a first request) may be configured to query an attribute and status of the memory. The task management request (i.e., a second request) may be configured to manage and control task execution of the memory. That is to say, the pre-erase command may be added to the preset request. Then, the preset request may be sent to the memory, such that the memory may perform the pre-erase operation based on the pre-erase command in the preset request.

In the embodiments of the present disclosure, any one of the above-mentioned three manners may be selected to send the pre-erase command. However, considering reducing an impact on the interaction with the memory, the first manner may be configured to issue the pre-erase command matching with the target pre-erase mode in the embodiments of the present disclosure.

Therefore, in the embodiments of the present disclosure, the pre-erase mode for the memory may be determined based on current data writing situation of the storage system. In this way, the pre-erase operation of the memory may be enabled to be combined with the application scenario of the storage system, such that the pre-erase operation may be more compatible with current data writing requirements of the storage system, and the arrangement of the pre-erase operation may be more reasonable.

As illustrated in Fig. 7, the method may be applied to the above-mentioned host. For the convenience of description, in the following embodiments, a case where the memory is a UFS may be used as an example for description. Of course, the memory may also be of another type, which is not limited herein. The method may include the operations from the operation at block S710 to the operation at block S780.

The operation at block S710: determining the application program running on the host.

As mentioned above, the target pre-erase mode may be determined based on the application program running on the host. Therefore, in the embodiments of the present disclosure, the application program running on the host may be determined first.

In some embodiments, taking the host as a smart phone for example, the running application program may be an application program running in foreground and/or background of the smart phone. In the embodiments of the present disclosure, the running application program may be an active application program. The active application program may refer to an application program that has run in the foreground within a current time period and is currently running in the foreground or background. The active application program may also refer to the application program that has written data to the memory within the current time period. The active application program may further refer to the application program currently running in the foreground, or the application program currently reading and/or writing data.

In the case where the active application program is one that has run in the foreground within the current time period and is currently running in the foreground or background, the current time period may be a time period of a specified duration or a specified time length before the current moment. Then, the active application programs may include the application program currently running in the foreground and the application programs that have switched from the foreground to the background within the current time period. That is to say, considering that the application programs switched to the background by the user recently may be switched back to the foreground again, all application programs that have run in the foreground within the current time period may be regarded as the active application programs, i.e., the aforementioned running application programs.

In the case where the active application program is one that has written data to the memory within the current time period and is currently running in the foreground or background, the electronic device may determine the application programs currently running in the foreground or background of the electronic device as candidate application programs. Then, among the candidate application programs, the application programs that have written data to the memory within the current time period may be found and taken as active application programs, i.e., the aforementioned running application programs. The application programs that have written data to the memory may be further restricted to those whose written data volume to the memory is greater than a specified data volume. Therefore, among all application programs currently running in the foreground and background of the electronic device, the application programs that have written data recently may be taken as active application programs, i.e., the application programs running on the host.

In the embodiments of the present disclosure, the active application program may refer to the application program currently running in the foreground of the electronic device. That is to say, in the implementation of determining the application program running on the host, the application program currently running in the foreground of the host (i.e., the application program currently running in the foreground of the electronic device) may be determined.

The operation at block S720: determining whether there is a specified application program among the running application programs.

In some embodiments, the specified application program may be an application program in an application list. The application list may be a pre-statistically compiled list of application programs with a large number of sequential write operations. For example, a game-type application program may perform a large number of sequential write operations when executing an installation package installation operation or a version update operation. The large number of sequential write operations may refer to write operations that are continuously executed within a preset time period and whose written data volume is greater than a preset data volume. The application programs in the application list may be added manually, or determined by the host based on whether each application program has a large number of sequential write operations within a statistical time period, which is not limited herein.

Therefore, after the host determines the running application programs, the running application programs may be taken as active application programs and matched with each specified application program in the application list, to determine whether there is an application program identical to the specified application program. Assuming that the running application program is the one currently running in the foreground, it may be determined whether the application program belongs to the specified application programs in the application list. If YES, the operation at block S730 may be executed; otherwise, the operation at block S750 may be executed.

In some embodiments, in a case where the specified application program exists among the running application programs, determining that the application scenario, where the target pre-erase mode is the automatic mode host, is the first scenario; in a case where the specified application program does not exist among the running application programs, it is determined that the application scenario, where the target pre-erase mode is the active mode host, is the second scenario. In the embodiments of the present disclosure, one of the two application scenarios (i.e., a scenario where there is a specified application program among the running application programs and another scenario where there is no specified application program among the running application programs) may be named the first scenario, and another of the two application scenarios may be named the second scenario. In some embodiments, the first scenario and the second scenario may not be set. In a case where there is a specified application program among the running application programs, the target pre-erase mode may be directly determined as the automatic mode. In a case where there is no specified application program among the running application programs, the target pre-erase mode may be directly determined as the active mode. However, adoption of the first scenario and the second scenario may make it much easier to describe the scenarios of the active mode and the automatic mode.

The operation at block S730: determining the application scenario of the host as the first scenario.

That is to say, in a case where it is determined that there is a specified application program among the running application programs, the application scenario of the host may be determined as the first scenario.

As mentioned above, the application scenarios may include the first scenario and the second scenario, and the data write volume of the first scenario may be greater than that of the second scenario. Each specified application program in the application list may be a pre-determined application program with a large number of sequential write operations. Therefore, in a case where the specified application program runs, the application program may perform a large number of sequential write operations. Thus, the application scenario where the specified application program runs may be defined as the first scenario. Accordingly, the application scenario where no specified application program runs may be defined as the second scenario. This configuration conforms to a setting that the data write volume of the first scenario is greater than that of the second scenario.

The operation at block S740: determining the target pre-erase mode for the memory as the automatic mode.

If the application scenario is the first scenario, the target pre-erase mode for the memory may be determined as the automatic mode. That is to say, for application scenarios with a large number of sequential writes, an application list may be preset. The automatic mode may be enabled during the operation of these applications.

The operation at block S750: sending the first erase instruction to the memory, to trigger the memory to enter the automatic mode.

The pre-erase instruction matching with the automatic mode may be the first erase instruction. The function of the first erase instruction may be to trigger the memory to enter the automatic mode. The first erase instruction may be sent in any of the aforementioned three manners. In the embodiments of the present disclosure, the first erase instruction may be sent in the first manner.

In some embodiments, there may be a device management unit matching with the memory. The device management unit may be a controller in the memory. In addition, in the host system using the universal flash storage (UFS) as a storage device, firmware of the UFS may manage the medium (NAND flash) by taking a virtual block (VB) as a unit. In the UFS, a storage area may be divided into a plurality of physical blocks. Each physical block may include a plurality of sectors. The volume of each sector may usually be 512 bytes or 4 KB. A virtual block may be a layer of logical mapping built on physical blocks. A plurality of physical blocks may be combined into a logical block, and a virtual address may be assigned to the logical block. Through mapping of virtual blocks, more efficient data reading, writing and management may be realized. For example, in the UFS, if a bad block occurs, the virtual block may automatically remove the bad block from the logical block and migrate data to other available physical blocks, thereby ensuring data integrity and reliability. In addition, virtual blocks may also realize high-speed random read/write operations of the UFS, as well as functions, such as optimization and support, or the like, for the TRIM command.

In the UFS memory, the pre-erase operation may usually be performed by the controller inside the memory, i.e., the aforementioned device management unit. For example, the UFS controller inside the memory may be responsible for managing and executing the erase operation. The controller of the memory may find free physical blocks through VB to perform the erase operation.

For example, the implementation manner of sending the first erase instruction to the memory to trigger the memory to enter the automatic mode may be as follows.

In the automatic mode, the first erase instruction may be sent to the memory. The memory may erase the free physical block of a first volume in the memory, and take the free physical block as a pre-erased block. In a case where it is detected that the data volume written to the pre-erased block is greater than a threshold, the operation of erasing the free physical block of the first volume in the memory, and take the free physical block as the pre-erased block may be performed again until the automatic mode ends. The first volume may be a pre-erase volume specified by the host and included in the first erase instruction. That is to say, the host may trigger the memory to automatically perform the pre-erase operation and reserve a pre-erased physical space of the first volume, i.e., the pre-erased block. The free physical block may refer to a storage block on a storage medium (such as a solid-state drive, a flash memory, or the like) that has not been used or allocated to any data. A physical block may be a smallest writable unit of a storage medium, and the physical block may usually have a fixed volume. In the storage device, physical blocks may be organized into continuous blocks for storing data. When data is deleted or moved, the matched physical blocks may become free physical blocks and may be reused for storing new data. Therefore, the volume of the pre-erased block may usually refer to or be based on the number of physical blocks that have undergone the pre-erase operation.

That is to say, in the automatic mode, after the host enables a pre-erase of the Auto mode of the memory through the first erase instruction, and specifies the pre-erase volume (i.e., the first volume) and the VB usage mode, the UFS device may automatically perform pre-erasure to the first volume after an idle period of read operations and/or write operations. The VB usage mode would be described in subsequent description. After the pre-erased blocks are consumed by write operations, the device may automatically perform pre-erasure according to its own idle state, so as to supplement the pre-erased blocks to the set volume. When the host issues a command to turn off the Auto mode, the device may stop automatic pre-erasure. The pre-erased blocks would be gradually consumed by subsequent write operations.

Therefore, the host may specify the following contents in the pre-erase command: a) pre-erase mode: automatic mode (Auto mode) or active mode (Host trigger mode); b) VB usage mode: including the currently commonly used NAND flash SLC/TLC/QLC modes, including but not limited to medium usage modes of new media such as MRAM/PCM/XL-Flash, or the like; c) volume configuration: the host may configure the size of the pre-erase volume within a certain range.

The operation at block S760: determining the application scenario of the host as the second scenario.

That is to say, if it is determined that there is no specified application program among the running application programs, the application scenario of the host may be determined as the second scenario.

The operation at block S770: determining the target pre-erase mode for the memory as the active mode.

The implementation manners of the second scenario and the active mode may refer to the aforementioned contents.

The operation at block S780: sending the second erase instruction to the memory, instructing the memory to perform the pre-erase operation on the free physical block in the memory to obtain a pre-erased space.

In the active mode, the second erase instruction may be sent to the memory, the memory may be instructed to perform the pre-erase operation on the free physical block in the memory, so as to obtain the pre-erased space. That is to say, in the active mode, the host may specify the volume of the pre-erased space as a second volume, and the memory may erase the free physical block of the second volume to obtain the pre-erased space of the second volume, i.e., the pre-erased block. Therefore, in a case where the host detects that the specified application program is active at the application layer, the host may determine the application scenario as the first scenario and issue an instruction (i.e., an instruction of "open auto pre-erase") to start the automatic mode to a driver layer. Then, the driver layer may send the pre-erase command, configured to enable the Auto mode (i.e., the first erase instruction), to the memory. For example, the driver layer may use the EHS field of a command such as "write (10)", or the like, to issue the pre-erase command for enabling the Auto mode. That is to say, the first erase instruction may be sent to the memory in the aforementioned first manner. Among them, "write (10)" is a write command, "(10)" indicates that this is a 10-byte write command for writing data.

In the automatic mode, the host may also need to determine whether the automatic mode ends. If the automatic mode ends, the host may need to send a first shutdown instruction to the memory, and the first shutdown instruction may be configured to turn off the automatic mode. The determination of whether the automatic mode ends may include returning to execute the operation of determining the application program running on the host again. The end of the automatic mode may include switching to the active mode, or switching to a state that is neither the active mode nor the automatic mode. For example, in the state, no application is running currently. Similarly, the end of the active mode may also be determined in this way.

In addition, the NAND flash has different usage modes for a physical block, and different modes may allow different numbers of bits to be stored in each minimum unit. The different modes may for example be the SLC/MLC/TLC/QLC modes. Usually, the number of bits stored in the minimum unit matching with the SLC is 1 bit. The number of bits stored in the minimum unit matching with the MLC is 2 bits. The number of bits stored in the minimum unit matching with the TLC is 3 bits. The number of bits stored in the minimum unit matching with the QLC is 4 bits. Therefore, during the pre-erase operation of the memory, while sending the pre-erase instruction matching with the target pre-erase mode, the usage mode matching with the pre-erase operation may also be sent, such that the memory may perform the pre-erase operation in this usage mode. That is to say, the host may specify the usage mode of the pre-erased VB.

In some embodiments, under different usage modes, preconditions for the memory to execute the pre-erase operation in response to the pre-erase instruction may be different.

For example, in a case where the VB usage mode specified by the host for the current pre-erase operation is the single-level cell (SLC) mode, the precondition for the memory to respond to the pre-erase instruction may be that the Write Booster (WB) buffer of the memory is available. That is, in a case where WB available buffer size! = 0, i.e., the WB buffer is not empty, the pre-erase operation in the SLC mode issued by the host may be executed by the memory. In a case where the WB buffer of the memory is unavailable, the memory has insufficient volume, the memory may return a failure message to the host. The host may know, through the failure message, that the current pre-erase operation could not be executed successfully.

The SLC mode is a memory operation mode in UFS devices. The SLC mode may use a higher unit density (i.e., each storage unit may store one bit) to achieve larger volume and provide faster data transmission speed. In the SLC mode, the UFS device may usually include a dedicated WB (Write Booster) buffer. The WB buffer is usually a high-speed storage area, which may be configured to temporarily store write data from the host system, such that the data may be written to the storage medium of the UFS device in batches at an appropriate timing.

When the host system needs to perform the write operation, the data may first be written to a WB buffer of the UFS device. However, before performing the erase operation, the UFS device must ensure that all data in the WB buffer has been written to the storage medium, so as to avoid data loss or data inconsistency. Therefore, in the SLC mode, the UFS device may usually check whether the WB buffer is empty before performing the erase operation. If the WB buffer still contains data to be written, the UFS device may first organize the data properly and write the data to the memory in batches, and may then perform the erase operation. Therefore, when the WB buffer is not empty, the failure message may be returned, and the host may need to send the pre-erase instruction again.

In addition, in a case where the usage mode specified by the host for the current pre-erase operation is the triple-level cell (TLC) mode or the quad-level cell (QLC) mode, a precondition for the memory to respond to the pre-erase instruction may be that: the number of current free physical blocks meets a preset requirement. The preset requirement may be that the number of the free physical blocks is greater than a first number. The first number may be set according to actual usage requirements. In a case where the number of free physical blocks is less than or equal to the first number, it may be indicated that, the memory has insufficient free physical blocks. Therefore, in a case where the memory determines that the number of the current free physical blocks is less than or equal to the first number, the memory may return the failure message to the host.

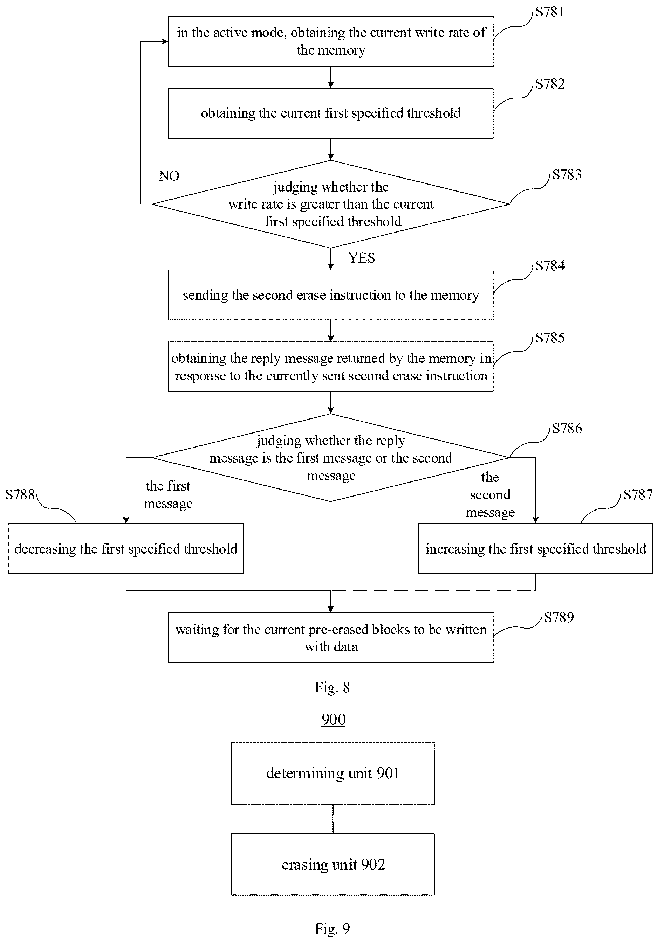

In a case where the application program currently running on the electronic device is not the specified application program, it may be indicated that, the current application scenario does not involve a large volume of data writing (i.e., there is no large number of sequential writes). This may mean that, there may be data write operations currently, but the volume of written data is not large; this may also mean that, the current scenario may be a data writing scenario but the written data is very small. Therefore, it may be necessary to determine, based on the write rate, whether this is a case where the volume of written data is not large. Thus, as illustrated in Fig. 8, the operation at block S780 may include the operation at block S781 to the operation at block S789.

The operation at block S781: in the active mode, obtaining a current write rate of the memory.

The current write rate may be the write rate within a preset duration matching with the current moment. That is to say, the write rate may be the volume of data written to the memory within the preset duration matching with the current moment. Therefore, an implementation manner of obtaining the current write rate of the memory may be: obtaining the number of specified write commands sent to the memory within the preset duration matching with the current moment, and taking the number as the write rate. The specified write command may be configured to write a data block of a specified data volume. For example, the specified data volume may be 512KB. Generally, relatively large data write operations may usually be split by a block layer of the operating system, so as to adapt to characteristics of the underlying storage device. In current storage devices, data read and write operations may be performed in units of blocks, and the size of blocks may be configured according to specific storage devices and file systems. Common block sizes are 512 KB, 1 KB, 2 KB, 4 KB, or the like. In the embodiments of the present disclosure, the size of the data block may be 512 KB, so that the specified write command may be configured to write a data block of 512 KB. Thus, the number of written data blocks may measure the volume of data written within a period of time. Since the specified write command is configured to write the data block of a specified data volume, the number of specified write commands may reflect the size of written data volume. Therefore, the number of specified write commands sent to the memory within the preset duration matching with the current moment may be used as the write rate. For example, the preset duration may be 100 ms, such that the write rate may be represented by the number n of 512 KB chunk-size write commands within 100 ms. The "chunk size" may refer to a parameter configured to control a block size or buffer size of the data write operation.

A time period of the preset duration matching with the current moment may be named the current time period. The duration of the current time period may be the preset duration, and the end time of the current time period may be the current moment. Therefore, if the current moment changes, the current time period may still be different even if the preset duration is the same.

The operation at block S782: obtaining the current first specified threshold.

The first specified threshold may be configured to determine whether the pre-erase operation needs to be triggered in the active mode under the current write rate. The first specified threshold may be variable, and the variation manner may be referred to subsequent descriptions. Since the first specified threshold is variable, it may be necessary to firstly obtain the current first specified threshold before each execution of judging whether the write rate is greater than the current first specified threshold.

The operation at block S783: judging whether the write rate is greater than the current first specified threshold.

The operation at block S784: sending the second erase instruction to the memory.

In a case where the write rate is greater than the current first specified threshold, the operation at block S784 may be executed; In a case where the write rate is less than or equal to the current first specified threshold, the process may return to the operation at block S781. Of course, the process may also return to execute the operation of determining the application program running on the host and the subsequent operations.

The sending manner of sending the second erase instruction to the memory may be referred to the aforementioned description, which would not be repeated here.

The operation at block S785: obtaining a reply message returned by the memory in response to the currently sent second erase instruction.

In the embodiments of the present disclosure, after the memory receives the first erase instruction or the second erase instruction, the memory may send the reply message to the host. The reply message may include the failure message, a success message, a first message, and a second message. The failure message (fail) may indicate that, the memory is unable to execute the current pre-erase operation. For example, the command requires pre-erasing the VB in the SLC mode, but the WB buffer is 0, or the number of free blocks is insufficient. The implementation manner of the memory sending the failure message (fail) may be referred to the aforementioned embodiments, which would not be repeated here. If the memory successfully executes the pre-erase operation, the memory may send the success message (Success) to the host. The "Success" may indicate that, the pre-erase of the set volume matching with the pre-erase operation has been completed. For example, the first erase instruction may be configured to instruct the memory to automatically erase the free physical blocks of the first volume, i.e., each pre-erase operation may cause the pre-erased blocks of the first volume. The second erase instruction may be configured to instruct the memory to obtain the pre-erased blocks of the second volume. Therefore, the memory may return the success message after successfully obtaining the pre-erased blocks of the matched volume.

In some embodiments, in a case where the host determines that the current write rate is greater than the current first specified threshold, the host may send the second erase instruction to the memory. After receiving the second erase instruction, the memory may determine whether the current remaining volume of the pre-erased space obtained by the last pre-erase operation is less than a second specified threshold. In a case where the current remaining volume is less than the second specified threshold, the memory may return the first message. In a case where the current remaining volume is greater than or equal to the second specified threshold, the memory may return the second message. After returning the first message or the second message this time, the pre-erase operation may be executed based on the second erase instruction. The last pre-erase operation may refer to the pre-erase operation performed before receiving the second erase instruction this time. The first message and the second message may reflect issue efficiency of the second erase instruction this time.

The first message (efficient) may be configured to indicate that, the current remaining volume of the pre-erased space obtained by the last pre-erase operation of the memory is less than the second specified threshold. The second message (inefficient) may be configured to indicate that, the current remaining volume of the pre-erased space obtained by the last pre-erase operation of the memory is greater than or equal to the second specified threshold. It may be seen that, after receiving the first message, the host may determine that, the volume of the pre-erased space obtained by the last pre-erase operation of the memory is insufficient. In other words, there is not enough space for writing data. Therefore, the first message may be returned to notify the host that, a usage efficiency of the pre-erased blocks obtained by the current pre-erase operation is relatively high. In other words, an issuing efficiency of the second erase instruction this time is relatively high. Similarly, after receiving the second message, the host may determine that, the volume of the pre-erased space obtained by the last pre-erase operation of the memory is still sufficient. In other words, there is still a certain volume of space not written with data. Therefore, the second message may be returned to notify the host that, the usage efficiency of the pre-erased blocks obtained by the current pre-erase operation is relatively low. In other words, the issuing efficiency of the second erase instruction this time is relatively low.

The operation at block S786: judging whether the reply message is the first message or the second message.

The operation at block S787: increasing the first specified threshold.

The operation at block S788: decreasing the first specified threshold.

As mentioned above, a precondition for sending the second erase instruction to the memory may be that, it is determined that, the current mode is the active mode, and the current write rate of the memory is greater than the current first specified threshold. Therefore, by changing the first specified threshold, a frequency of sending the second erase instruction to the memory may be adjusted. In other words, dynamic adjustment of the issuing frequency of pre-erase by the host may be facilitated. It may be seen that, if the first specified threshold is increased this time, when determining whether to issue the second erase instruction based on the write rate next time, the write rate may need to be larger to meet the condition that the next write rate is greater than the first specified threshold used the next time. That is to say, the write operation may need to be more active to send the second erase instruction, which may reduce the issuing frequency of the second erase instruction to a certain extent. Similarly, if the first specified threshold is decreased this time, when determining, based on the write rate, whether to issue the second erase instruction next time, the write rate may be less while meeting the condition that the next write rate is greater than the first specified threshold used the next time. That is to say, the sending of the second erase instruction may be triggered more easily, which may increase the issuing frequency of the second erase instruction.

Therefore, it may be judged whether the reply message is the first message or the second message. In a case where the reply message is the first message, the first specified threshold may be decreased. In a case where the reply message is the second message, the first specified threshold may be increased.

The operation at block S789: waiting for the current pre-erased blocks to be written with data.

After returning the first message or the second message, the memory may execute the pre-erase operation, and wait for the current pre-erased blocks to be written with data. In a case where the active mode has not ended, in other words, the application scenario is still the second scenario, the process may return to execute the operation of obtaining the current write rate of the memory and the subsequent operations. That is to say, the write rate detection operation may continue, and the first specified threshold used next time may be the first specified threshold that has been adjusted this time based on the first message or the second message.

In some embodiments, the first specified threshold may have an initial value. When the current active mode ends or the next active mode begins, the first specified threshold may be initialized. In other words, the first specified threshold may be set to the initial value. In addition, the first specified threshold may also have an upper limit value and a lower limit value, such that the first specified threshold may not be increased or decreased blindly. Therefore, the implementation manner of "in a case where the reply message is the first message, the first specified threshold may be decreased" mentioned above may be: in a case where the reply message is the first message, determining whether the current first specified threshold is less than or equal to the lower limit value; in a case where the current first specified threshold is less than or equal to the lower limit value, keeping the first specified threshold as the lower limit value; in a case where the current first specified threshold is greater than the lower limit value, decreasing the first specified threshold. Similarly, the implementation manner of "in a case where the reply message is the second message, the first specified threshold may be increased" may be: in a case where the reply message is the second message, determining whether the current first specified threshold is greater than or equal to the upper limit value; in a case where the current first specified threshold is greater than or equal to the upper limit value, keeping the first specified threshold as the upper limit value; in a case where the current first specified threshold is less than the upper limit value, decreasing the first specified threshold.

Therefore, in the first scenario, i.e., when there are a large number of write operations, the automatic mode may be adopted. This may allow the memory to automatically execute the pre-erase operation in a timely manner based on the current free physical state, avoiding a situation where the host triggers the pre-erase operation too late. In scenarios where there are no large number of write operations, the active mode may be used. This may avoid long-term existence of pre-erased blocks in the memory, which may lead to stability risks.

Therefore, through the detection of the running specified application program, it may be determined whether to enter the active mode or the automatic mode. This may enable the automatic mode to be used in scenarios with a large number of sequential writes, thereby increasing the pre-erase benefit of write operations.

Fig. 9 is a structural block diagram of a memory management apparatus 900 according to an embodiment of the present disclosure. The memory management apparatus 900 may include: a determining unit 901 and an erasing unit 902.

The determining unit 901 may be configured to determine the target pre-erase mode among the automatic mode and the active mode. In the automatic mode, the memory may automatically perform the pre-erase operation on the memory. In the active mode, the memory may perform, according to an instruction sent by the host, the pre-erase operation.

In some embodiments, the determining unit 901 may be further configured to: determine the application program running on the host; determine, based on the running application program, the target pre-erase mode among the automatic mode and the active mode.

In some embodiments, the determining unit 901 may be further configured to: if the specified application program exists among the running application programs, determine that, the application scenario, where the target pre-erase mode is the automatic mode host, is the first scenario; if the specified application program does not exist among the running application programs, determine, the application scenario, where the target pre-erase mode is the active mode host, is the second scenario.

The erasing unit 903 may be configured to perform, based on the target pre-erase mode, the pre-erase operation on the memory.

In some embodiments, the erasing unit 903 may be further configured to send the first erase instruction to the memory, so as to trigger the memory to enter the automatic mode. In the automatic mode, the memory may automatically perform the pre-erase operation on the free physical block in the memory, so as to obtain the pre-erased space.

In some embodiments, the erasing unit 903 may be further configured to: in the active mode, send the second erase instruction to the memory, thereby instructing the memory to perform the pre-erase operation on the free physical block in the memory, to obtain the pre-erased space.

In some embodiments, the erasing unit 903 may be further configured to: in the active mode, obtain the current write rate of the memory; in a case where the write rate is greater than the current first specified threshold, send the second erase instruction to the memory.

In some embodiments the erasing unit 903 may be further configured to: obtain the number of specified write commands sent to the memory within a preset duration matching with the current moment, and use the number as the write rate. The specified write command may be configured to write the data block of the specified data volume.

In some embodiments, the erasing unit 903 may be further configured to: after sending, in a case where the write rate is greater than the specified threshold, the erase instruction to the memory, obtain the reply message returned by the memory in response to the currently sent second erase instruction; in a case where the reply message is the first message, reduce the first specified threshold. The first message may be configured to indicate that, the current remaining volume of the pre-erased space obtained by the last pre-erase operation of the memory is less than the second specified threshold. The last pre-erase operation may refer to the pre-erase operation performed before receiving the second erase instruction this time. The erasing unit 903 may be further configured to: in a case where the reply message is the second message, increase the first specified threshold. The second message is configured to indicate that, the current remaining volume of the pre-erased space obtained by the last pre-erase operation of the memory is greater than or equal to the second specified threshold. In a case where the application scenario is still the second scenario, the erasing unit 903 may be configured to: return to execute the operation of obtaining the current write rate of the memory and subsequent operations.

In some embodiments, the erasing unit 903 may be further configured to: obtain the pre-erase command matching with the target pre-erase mode; add the pre-erase command to the preset field of the specified instruction to be sent to the memory, to obtain the target instruction; send the target instruction to the memory, such that the memory may perform, based on the pre-erase command, the pre-erase operation.

It is clear to those skilled in the related art that, for the sake of convenience and brevity, the specific operating processes of the above-described apparatuses and modules may be referred to the corresponding processes in the foregoing method embodiments, which would not be repeated here.

In several embodiments provided in the present disclosure, coupling between modules may be electrical, mechanical, or in other forms.

In addition, each function module in the various embodiments of the present disclosure may be integrated into one processing module, or may be physically separate modules, or two or more modules may be integrated into one module. The integrated module may be implemented either in the form of hardware or software functional module.

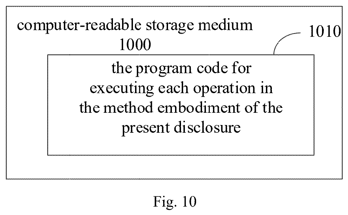

Fig. 10 illustrates a structural block diagram of a computer-readable medium according to an embodiment of the present disclosure. A computer-readable medium 1000 may store a program code. The program code may be invoked by a processor to execute the methods described in the above-mentioned method embodiments.

The computer-readable medium 1000 may be an electronic storage device such as a flash memory, an electrically erasable programmable a read-only memory (EEPROM), an EPROM, a hard disk, a ROM, or the like. In some embodiments, the computer-readable medium 1000 may include a non-transitory computer-readable storage medium. The computer-readable medium 1000 may have a storage space for a program code 1010 that is configured to execute any of the method operations in the aforementioned methods. The program code may be read from or written into one or more computer program products. For example, the program code 1010 may be compressed in an appropriate form.

In summary, the memory management method, the apparatus, the storage system, and the computer-readable medium provided in the present disclosure may: determine the application scenario of the storage system; determine, based on the application scenario, the target pre-erase mode for the memory from a plurality of preset pre-erase modes; perform, based on the target pre-erase mode, the pre-erase operation on the memory. Therefore, the pre-erase mode for the memory may be determined based on the current data writing situation of the storage system. In this way, the pre-erase operation of the memory may be enabled to be combined with the application scenario of the storage system, such that the pre-erase operation may be more compatible with the current data writing requirements of the storage system, and the arrangement of the pre-erase operation may be more reasonable.

In addition, pre-erasing the VB may save a significant amount of time required for VB erasure during sequential writing, enhance the sequential write performance of the storage system, and reduce latency spikes (i.e., a maximum latency) caused by VB erasure. The host and a device may operate in conjunction to perform on-demand pre-erasure through scenario recognition. This may ensure maximum benefits while preventing pre-erased blocks from persisting for an extended period, thereby mitigating the stability risks associated with existing technical schemes. The technical scheme 1 does not adopt separate commands, instead, the technical scheme 1 may utilize the EHS field or reserved fields of the UPIU, which has no impact on the operational performance of the user.

Finally, it should be noted that: the above-mentioned embodiments are merely for illustrating the technical scheme of the present disclosure, and not for restricting the same. Although the present disclosure has been described in detail with reference to the aforementioned embodiments, those of ordinary skills in the art should appreciate that: the technical schemes documented in the aforementioned embodiments may still be modified or some of the technical features therein may be equivalently substituted. Such modifications or substitutions do not render the essence of the corresponding technical schemes departing from the spirit and scope of the technical schemes of the embodiments of the present disclosure.

## Claims

1. A memory management method, **characterized by** being performed by a host of a storage system, the storage system further comprising a memory, the host being connected to the memory, and the method comprising:
determining a target pre-erase mode among an automatic mode and an active mode; wherein in the automatic mode, the memory automatically performs a pre-erase operation on the memory; in the active mode, the memory performs, according to an instruction sent by the host, the pre-erase operation; and
performing, based on the target pre-erase mode, the pre-erase operation on the memory.

2. The method as claimed in claim 1, wherein
the determining the target pre-erase mode among the automatic mode and the active mode comprises:
determining an application program running on the host; and
determining, based on the running application program, the target pre-erase mode among the automatic mode and the active mode.

3. The method as claimed in claim 2, wherein
the determining, based on the running application program, the target pre-erase mode among the automatic mode and the active mode comprises:
in a case where there is a specified application program in the running application program, determining the target pre-erase mode as the automatic mode; and
in a case where there is no specified application program in the running application program, determining the target pre-erase mode as the active mode.

4. The method as claimed in claim 1, wherein
the determining the target pre-erase mode among the automatic mode and the active mode comprises:
determining an application scenario of the storage system; and
determining, based on the application scenario, the target pre-erase mode among the automatic mode and the active mode.

5. The method as claimed in claim 4, wherein
the determining, based on the application scenario, the target pre-erase mode among the automatic mode and the active mode comprises:
in a case where the application scenario is a first scenario, determining the target pre-erase mode as the automatic mode; and
in a case where the application scenario is a first scenario, determining the target pre-erase mode as the active mode;
wherein a data write volume of the first scenario is greater than that of the second scenario.

6. The method as claimed in claim 1, wherein
the target pre-erase mode is the automatic mode, and, the performing, based on the target pre-erase mode, the pre-erase operation on the memory comprises:
sending a first erase instruction to the memory, to trigger the memory to enter the automatic mode;
wherein in the automatic mode, the memory automatically performs the pre-erase operation on a free physical block in the memory to obtain a pre-erased space.

7. The method as claimed in claim 1, wherein
the target pre-erase mode is the active mode, and, the performing, based on the target pre-erase mode, the pre-erase operation on the memory comprises:
in the active mode, sending a second erase instruction to the memory, to instruct the memory to perform the pre-erase operation on a free physical block in the memory, to obtain a pre-erased space.

8. The method as claimed in claim 7, wherein
the in the active mode, sending the second erase instruction to the memory comprises:
in the active mode, obtaining a current write rate of the memory; and
in a case where the write rate is greater than a current first specified threshold, sending the second erase instruction to the memory.

9. The method as claimed in claim 8, wherein
the obtaining the current write rate of the memory comprises:
obtaining the number of specified write commands sent to the memory within a preset duration matching with the current moment, and using the number as the write rate;
wherein the specified write command is configured to write a data block of a specified data volume.

10. The method as claimed in claim 8, wherein
after in a case where the write rate is greater than the specified threshold, sending the erase instruction to the memory, the method further comprises:
obtaining a reply message returned by the memory in response to the currently sent second erase instruction;
in a case where the reply message is a first message, reducing the first specified threshold; wherein the first message is configured to indicate that, a current remaining volume of the pre-erased space obtained by a last pre-erase operation of the memory is less than a second specified threshold; the last pre-erase operation refers to the pre-erase operation performed before receiving the second erase instruction this time;
in a case where the reply message is a second message, increasing the first specified threshold; wherein the second message is configured to indicate that, the current remaining volume of the pre-erased space obtained by the last pre-erase operation of the memory is greater than or equal to the second specified threshold; and
in a case where the active mode has not ended, returning to perform the operation of obtaining the current write rate of the memory and subsequent operations.

11. The method as claimed in any one of claims 1-10, wherein
the performing, based on the target pre-erase mode, the pre-erase operation on the memory comprises:
obtaining a pre-erase command matching with the target pre-erase mode;
adding the pre-erase command to a preset field of a specified instruction to be sent to the memory, to obtain a target instruction; and
sending the target instruction to the memory, such that the memory performs, based on the pre-erase command, the pre-erase operation.

12. The method as claimed in claim 11, wherein
the specified instruction to be sent to the memory is a write instruction or a read instruction that is currently to be sent to the memory by the host.

13. The method as claimed in claim 12, wherein
the specified instruction is the read instruction or the write instruction in a universal flash storage (UFS) protocol information unit; the preset field is an extra header segment.

14. The method as claimed in any one of claims 1-10, wherein
the performing, based on the target pre-erase mode, the pre-erase operation on the memory comprises:
obtaining a pre-erase command matching with the target pre-erase mode;
generating, based on a UFS protocol information unit (UPIU) protocol, a pre-erase instruction from the pre-erase command; and
sending the pre-erase instruction to the memory, such that the memory performs, based on the pre-erase instruction, the pre-erase operation.

15. The method as claimed in any one of claims 1-10, wherein
the performing, based on the target pre-erase mode, the pre-erase operation on the memory comprises:
obtaining a pre-erase command matching with the target pre-erase mode;
adding the pre-erase command to a preset request; and
sending the preset request to the memory, such that the memory performs, based on the pre-erase command in the preset request, the pre-erase operation.

16. The method as claimed in claim 15, wherein
the preset request comprises a first request or a second request;
the first request is configured to query an attribute and a status of the memory, and
the second request is configured to manage and control task execution of the memory.

17. The method as claimed in any one of claims 1-16, wherein
the memory is a universal flash storage.

18. A memory management apparatus, **characterized by** being applied to a host of a storage system, the storage system further comprising a memory, the host being connected to the memory, and the apparatus comprising:
a determining unit, configured to determine a target pre-erase mode among an automatic mode and an active mode; wherein in the automatic mode, the memory automatically performs a pre-erase operation on the memory; in the active mode, the memory performs, according to an instruction sent by the host, the pre-erase operation; and
an erasing unit, configured to perform, based on the target pre-erase mode, the pre-erase operation on the memory.

19. A storage system, **characterized by** comprising:
a host; and
a memory;
wherein the host is connected to the memory, and the host is configured to execute the method as claimed in any one of claims 1-17.

20. A computer-readable medium, **characterized in that**:
the computer-readable medium stores a program code executable by a processor;
the program code, when being executed by the processor, enables the processor to execute the method as claimed in any one of claims 1-17.
